# EUROPEAN PATENT SPECIFICATION

(11) **EP 4 111 542 B1**
(45) Date of publication and mention of the grant of the patent: **15.05.2024**
(21) Application number: 21707946.6
(22) Date of filing: 23.02.2021
(51) Int. Cl.: H01Q 7/00, H01Q 23/00, H01Q 5/25, H01Q 1/02, G01S 13/88, G01S 13/02, H03F 3/24, H03F 3/45, H01Q 17/00

(54) **ULTRA-WIDE BAND ANTENNA SYSTEM**
ULTRABREITBANDANTENNENSYSTEM
SYSTÈME D'ANTENNE À BANDE ULTRA-LARGE

(30) Priority: 27.02.2020 NL 2025004
(43) Date of publication of application: 04.01.2023
(73) Proprietor: Ilmsens GmbH, 98693 Ilmenau (DE)
(72) Inventor: SACHS, Jürgen, 98693 Ilmenau (DE); JUST, Thomas, 98693 Ilmenau (DE); PECOVSKY, Martin, 98693 Ilmenau (DE)
(74) Representative: Octrooibureau Van der Lely N.V.
(86) International application number: PCT/EP2021/054393
(87) International publication number: WO 2021/170557

(56) References cited:
- US-A1- 2014 208 582
- US-B1- 10 276 931
- PECOVSKY MARTIN ET AL: "Electrically short active antennas for M-sequence UWB systems", 2017 27TH INTERNATIONAL CONFERENCE RADIOELEKTRONIKA (RADIOELEKTRONIKA), IEEE, 19 April 2017 (2017-04-19), pages 1-5, XP033100484, DOI: 10.1109/RADIOELEK.2017.7937588
- POCHANIN G P ED - ANONYMOUS: "Large Current Radiators", ULTRAWIDEBAND AND ULTRASHORT IMPULSE SIGNALS, THE THIRD INTERNATIONAL CONFERENCE, IEEE, PI, 1 September 2006 (2006-09-01), pages 77-81, XP031046653, DOI: 10.1109/UWBUS.2006.307163 ISBN: 978-1-4244-0513-8
- SCHANTZ H G ED - INSTITUTE OF ELECTRICAL AND ELECTRONICS ENGINEERS: "UWB magnetic antennas", IEEE ANTENNAS AND PROPAGATION SOCIETY INTERNATIONAL SYMPOSIUM. 2003 DIGEST. APS. COLUMBUS, OH, JUNE 22 - 27, 2003; [IEEE ANTENNAS AND PROPAGATION SOCIETY INTERNATIONAL SYMPOSIUM], NEW YORK, NY : IEEE, US, 22 June 2003 (2003-06-22), pages 604-607vol.3, XP032413566, DOI: 10.1109/APS.2003.1219920 ISBN: 978-0-7803-7846-9
- Gennadiy P Pochanin ET AL: "Ultrawideband Radar: Applications and Design. Chapter 10 : Large Current Radiators: Problems, Analysis, and Design" In: "Ultrawideband Radar: Applications and Design. Chapter 10 : Large Current Radiators: Problems, Analysis, and Design", 1 January 2012 (2012-01-01), XP055738396, ISBN: 978-1-4200-8986-8 pages 325-372, the whole document

## Description

The present invention relates to an ultra-wide band antenna system for emitting or receiving electromagnetic radiation in a desired ultra-wide frequency band. The antenna system comprises an electrically short radiator plate, a power unit with an input for receiving an input signal that is detected or to be emitted via the radiator plate, with a power supply and with a transistor circuit for amplifying the input signal, and furthermore comprises a current loop for electrically connecting the radiator plate and the power unit into an electrical loop. The current loop comprises a return conductor and a layer of absorber material between the radiator plate and the ground plane return conductor to absorb electromagnetic radiation in said desired frequency band, a first electrical lead connecting the radiator plate to the return conductor, and a second electrical lead connecting the return conductor to the power unit.

Such antenna systems are known in the art. E.g. US4,506,267 discloses a so-called "Large Current Radiator". By providing a current loop, with a shielded return lead, it is possible to provide higher currents in the radiator element, and thus generate stronger electric fields and signals, than in the case of a simple Hertzian dipole. The loop is made by connecting the radiator plate with trapezoidal leads to the lead wires of a power unit.

Reference is also made to US2014/208582, that discloses an ultra-wide band antenna system for emitting or receiving electromagnetic radiation in a desired ultra-wide frequency band. Its antenna system comprises an electrically short radiator plate, a power unit with an input for receiving an input signal that is detected or to be emitted via the radiator plate, and a power supply, and furthermore comprises a current loop for electrically connecting the radiator plate and the power unit into an electrical loop. The current loop comprises a return conductor and a ferrite loading layer, a shorting plate, and a second electrical lead that connects the power unit to the radiator plate.

Reference is also made to the article "Electrically short active antennas for M-sequence UWB systems", by Pecovsky et al., in "27th International Conference Radioelektronica" (2017), the article "Large Current Radiators" (anonymous), in "Ultrawideband and Ultrashort Impulse Signals, the Third International Conference, IEEE" (Pochanin G.P., ed.), and to "Ultrawideband Radar: Applications and Design, Chapter 10: Large Current Radiators: Problems, Analysis, and Design", pages 325-372, by Gennadiy P. Pochanin, all discussing the use of transistors to amplify the signals to be transmitted by such a Large Current Radiator.

In practice, it turns out that the known system does not provide optimum properties over a wide frequency band. In particular the upper cut-off frequency is often not sufficiently high and/or the required power at higher frequencies becomes too large.

It is therefore an object of the present invention to improve the known system, such that it has - improved emission properties, in particular a widened, useful frequency band.

Thereto, the invention provides an ultra-wide band antenna system of the kind mentioned above, according to claim 1

The inventor has realised that the total inductance of the current loop as a whole should be made smaller than has been realised in the prior art system. In this way the cut-off frequency may be increased and the power dissipation in the transistor is limited. Herein, the transistor is forced to provide only low voltages at high currents. The inductance of the radiator plate is largely determined by the geometry and dimensions of the radiator plate. However, the inductance of the other parts of the current loop, conveniently called "parasitic inductance" in what follows, should (also) be minimised.

A first measure to achieve this is to have a second electrical lead that is non-narrowing, instead of the trapezoidally narrowing lead of the known system. Note that a simple wire (which by itself is also non-narrowing) is specifically excluded herein as the second lead. Preferably, the second electrical lead widens from the radiator plate towards the power unit. These measures already lower the parasitic inductance, and provide a higher cut-off frequency and lower power at higher frequencies.

In the framework of the present invention, an "ultra-wide frequency band" means a frequency band between a lower frequency of at least 10 MHz and an upper frequency of up to 10 GHz, although it need not cover this whole range. The ultra-wide frequency band should also have a fractional bandwidth of at least 0.2 and, in an absolute sense, of at least 50 MHz. In specific cases, such as according to European regulations, this may be limited to having an absolute bandwidth of at least 500 MHz. Examples of such ultra-wide frequency bands are 30-300 MHz for ground penetrating radar, 100 MHz - 2 GHz for pavement monitoring and 0.5 - 5 GHz for medical imaging. Of course, other limits are also possible, both for the mentioned applications and for other applications.

The antenna system of the invention is useful as an emitter, that is, it receives an input signal from a signal generator, in principle an arbitrary wave generator, such as a sine wave generator that steps or sweeps the frequency over the desired band, a pulse generator, a (binary) pseudonoise generator and so on, which generator provides a signal of sufficiently large spectrum and preferably of nearly constant spectral power. The antenna system may also be used as a receiver, wherein the radiator plate actually works as a receiver antenna, and wherein the power unit amplifies the received signal. Of course, the amplifier should then be connected the other way around. It should then also preferably be selected as a low-noise amplifier, and so on. This will be explained further hereinbelow. Yet, in most of what follows, it is to be understood that the antenna system acts as an emitter. In case the antenna system is to be used as a receiver, the corresponding adaptation(s) is (are) to be made accordingly, as will be readily apparent to the skilled person.

Furthermore, "electrically short" means that the relevant dimension, such as the length of the radiator plate, is much shorter than the "characteristic length" of the signal (e.g. the (lowest) wavelength of the emitted electromagnetic radiation, the coherence length, and so on). The behaviour of the antenna will then largely be that of a dipole, which has a number of advantages in applications of the system, such as a spherical wavefront of the emitted radiation, a short impulse response and a short nearfield zone, and being able to operate over a large bandwidth at low mean frequency. In many applications, it is also important that the properties of the antenna are only minimally influenced by nearby, or even contacting, objects.

Other advantages and embodiments are described in the dependent claims, as well as in the following.

In embodiments, the second electrical lead widens from the radiator plate towards the ground plane. This will similarly further lower the parasitic inductance. Note that it may also suffice to have a non-widening, but flat and non-narrowing lead in order to decrease the parasitic inductance with respect to the prior art system. Herein, the second lead is neither a wire, but at least a rectangular plate, preferably a widening plate such as a trapezoidal plate or the like.

In embodiments, the first and/or second electrical lead widens linearly. This is a way of ensuring a widening lead that is easy to manufacture. However, it is also possible to select a different way in which the lead(s) widen(s), such as in a rounded-off fashion, exponentially and so on.

The return conductor in the current loop is a ground plane. It is a flat part, and the main property is a large width to enable a good current flow with low losses and parasitic inductance. Note that "ground plane" does not necessarily mean that the plate is kept at ground potential, although that is often convenient. It need neither necessarily have a completely plane surface, although, again, this is often convenient.

It is remarked that the absorber material is there to prevent that the electromagnetic radiation is reflected off the ground plate, which would cause unwanted interference of the signals. Often, though not necessarily, the absorber material and the ground plane are sandwiched, such as for support of the absorber material. It also helps in ensuring that the absorber material is provided over a sufficiently wide area to ensure that at its borders the emitted radiation is already sufficiently attenuated and is hardly or not diffracted.

In embodiments, at least the transistor circuit and the radiator plate are provided on the same side of the ground plane and of the layer of absorbing material. This allows to have a (very) short lead between the radiator plate and the relevant contact lead(s) of the transistor (circuit), contrary to the relatively long leads in the prior art systems. Note that the contact leads of transistors are often rather narrow, which could lead to relatively large parasitic inductances. With the measures according to the invention, this lead (or rather: the total lead length between transistor (circuit) and radiator plate) is now rather short and may also be made rather wide(ning), all of which helps to reduce the inductance.

Advantageously, the first electrical lead is arranged as a heat sink to the transistor circuit. The heat sink is in particular arranged to be an electrically conducting lead, that is arranged to conduct heat away from the transistor (circuit). Thereto, it will be in thermal contact with the transistor (circuit), and have dimensions that at the same time as good thermal conductance ensure a good electrical conductance, and thus low inductance as well. This is often ensured by means of a wide conductor, such as a block of material (often metal). Consequently, the first lead has good thermal properties, ensuring cooling of the transistor (circuit), as well as good electrical properties, functioning as a lead with low resistance and low inductance, and also providing structural strength, because of the metal material and its dimensions. The heat sink may have additional measures to promote the leading away of heat, such as fins or holes. There may also be forced cooling through a fan or the like.

In embodiments, the heat sink narrows towards the transistor circuit. This effectively means that the average distance between the radiator plate and the heat sink (i.e. the first lead) is increased, which means that the corresponding parasitic capacitance between the drain and source leads is lowered.

In embodiments, the radiator plate widens from the first electrical lead towards the second electrical lead. This measure increases the average distance between the radiator plate and the first lead, which means that the corresponding parasitic capacitance is lowered.

In the above, the transistor usually operates in the common-source mode. However, this is not necessary, and the transistor may also operate in e.g. the common-drain mode. Then, in embodiments, the radiator plate is arranged as a heat sink to the transistor circuit. In addition to this enabling good cooling of the transistor (circuit), it also helps in lowering the resistive losses, and also lowers the parasitic inductance of the radiator plate. It may be achieved by means of measures known perse, such as providing the radiator plate with a certain minimum thickness, or providing heat radiating structures such as ribs or wings, and/or to provide forced ventilation, holes in the radiator body, and so on.

In embodiments, the transistor circuit is arranged to have a decaying frequency-dependent gain curve in at least a part of said desired ultra-wide frequency band. In other words, the antenna system is to be supplied with a signal in a bandwidth in which the transistor (circuit) has a frequency-dependent drop in gain, preferably of 20 dB/decade. This is based on the following consideration. An electrically short antenna behaves more or less like an electric dipole, and thus has a far field electric field strength that is (substantially linearly) frequency-dependent. Thus, low frequency signals will be suppressed while high frequency signals will be much stronger. By using an input circuitry with a transistor circuit arranged to have a gain decay as described above, this effect is countered, and the total transfer function (behaviour) of the antenna system, in terms of the strength of the electric field normalised to the observation distance r as a function of frequency gives a flat curve, i.e. a truly frequency-independent system. At low frequencies, the "differentiation" (that would lead to a linear frequency dependence) of the radiator is the dominant factor, which effect is compensated for higher frequencies by the integrating effect of the frequency-dependent gain drop of the transistor curve. Finally, beyond the cut-off frequency of the LCR-transistor loop, which is mainly determined by the output-admittance of the transistor and the total LCR-inductance, the transfer function will start to decay. One could say that then a further signal integrating effect will become active, in addition to the integrator-like behaviour of the transistor itself.

All this, including advantageous measures and effects, are described in the Dutch patent application with application number 2025003, and also titled "Ultra-wide band antenna system", co-filed with the present application.

In embodiments, the system further comprises a signal generator arranged to generate an input signal for inputting into said input, in particular wherein the input signal substantially only has frequency components within said desired ultra-wide frequency band. In this way, the system is fully equipped to not only receive and emit the desired signal, but also to generate the signal itself. Herein, "the input signal substantially only has frequency components within said desired ultra-wide frequency band" means that the -3 dB cut-off frequencies lie within said frequency band. Note that it is also possible for the signal generator to generate signals with frequency components outside the desired ultra-wide frequency band. However, such components will not be attenuated in most cases, due to the cut-off effect, but they will neither be of any further relevance to most situations, because they will not lead to a useful, or even detected signal, or at least not interfere with the desired frequency band signals. But of course the signal generator should be arranged to generate an input signal for inputting into said input, wherein the input signal has at least a frequency component within said desired ultra-wide frequency band.

In embodiments, the ground plane and the layer of absorber material are sandwiched to a main printed circuit board, wherein at least the transistor circuit is provided in a package mounted on an additional printed circuit board that is sandwiched to the radiator plate, wherein the heat sink is provided to contact the ground plane and the package directly. In such embodiments, the main printed circuit board, or mother board, carries the main electronics, such as a signal generator or otherwise. The transistor circuit and the radiator plate are provided on the additional PCB and the leads are provided as spacers between the main and additional PCB, at the same time serving as heat sinks. This allows a simple and compact design, that is mainly useful in cases where (monolithically) integrated circuits for driving the radiator plate. For example for short-range sensing the radiated field need not be strong, so that the compact set-up may suffice.

Preferably, the package is provided between the main printed circuit board and the additional printed circuit board. In this way, the package, with the transistor circuit, is additionally protected between the two pcbs.

In embodiments, the system comprises a second antenna system, comprising a second electrically short radiator plate, a second power unit having an input for receiving an input signal to be emitted as a probing signal via the radiator plate, and a second transistor circuit for amplifying the input signal into the probing signal, a second current loop for electrically connecting the second radiator plate and the second power unit into a second electrical loop, the current loop comprising the ground plane and the layer of absorber material to absorb electromagnetic radiation in said desired frequency band, a first additional electrical lead connecting the second power unit to the ground plane, a second additional electrical lead connecting the ground plane to the second radiator plate.

These embodiments allow to have a twice as strong electric field in the far field, e.g. by differentially driving the transistor circuits and their corresponding radiators. Herein, the radiators may be provided symmetrically, with a central power supply and opposite current loops, or in a parallel fashion, again with opposite current loops but then having the first lead of one of the current loops near, or combined with, the second lead of the other current loop, and having the second lead of said one of the current loops near, or combined with, the first lead of said other of the current loops. The respective radiator plates are then positioned next to each other, instead of pointing away from each other. Preferably, the radiator plates are provided in parallel, more preferably in the same plane. Note, thus, that the (first) transistor circuit and the second transistor circuit are differentially fed, in order to prevent the two contributions from cancelling out.

It is expressly noted that all the additional measures described above for the "first" antenna system also hold for the second antenna system, such as having leads that function as heat sinks, the radiator plate widening away from the transistor circuit, and so on.

In particular embodiments, the radiator plate and the second radiator plate are both arranged on the additional printed circuit board, preferably wherein the power unit and the second power unit are both provided between the main printed circuit board and the additional printed circuit board. These embodiments, in particular those with side-by-side radiator plates, allow a very compact, yet powerful antenna system, in which the power units may be optimally protected. More in particular, both the transistor circuit and the second transistor circuit are provided in one and the same package. This allows an even better protection of the power units, by providing them in one and the same package, which is easily possible for e.g. integrated circuits.

In embodiments, the system further comprises a metal casing with electronic parts provided therein that are arranged to generate a probing signal or detect a detection signal by means of the antenna system, wherein the metal casing is substantially fully clad with an absorber material to absorb electromagnetic radiation in said desired frequency band. The metal casing corresponds more or less to the casing 11 in Fig. 4B/C of US4,506,267, but is now clad completely with absorber material. This provides the advantage that the "creeping waves", caused by the electromagnetic radiation emitted by the radiator plate into the surrounding air may diffract around the casing, are suppressed and no longer continue to travel. Non-coated metal cases will cause the creeping wave to interact with the original, desired wave. This will destroy the intended waveform of the transmitted wave leading e.g. to deteriorate resolution of microwave images. By completely cladding the electronics casing with absorber material, these creeping waves are suppressed further and further, thereby improving the resolution of the system. Note that this is in particular relevant for small antenna systems, with dimensions that are not large with respect to the spatial extension of the generated wave.

In particular embodiments, the radiator plate is external to the metal casing at a first side of said metal casing, the system further comprising a continuous wall extending from the metal casing and surrounding the radiator plate on all sides, wherein the wall is also clad with absorber material to absorb electromagnetic radiation in said desired frequency band. These embodiments are particularly useful when the antenna system is positioned against a surface of an object to be investigated. In free space, the radiator plate would emit electromagnetic radiation in all directions. Since the radiator plate is electrically small, and the casing will, in by far the most cases, not be large compared to the characteristic length (wavelength of radiation), the radiation will diffract around the casing, reflect off the metal casing and interfere with the emitted radiation. To counteract this phenomenon, the continuous wall clad with absorber is provided, that in use will surround the radiator plate and contact the surface of the object to be investigated. There, it will effectively absorb the emitted radiation in air. In this case, the metal casing need only be clad with absorber at the bottom between where the wall contacts the casing. In practice however, the full casing will often be clad, to prevent radiation leaking between the surface and the wall from yet interfering.

In all of the above, the term 'radiator plate' is used for the part that emits the electromagnetic radiation. However, the radiator plate may in fact also function as a receiver antenna, picking up electromagnetic signals. The antenna system of the present invention may then likewise function as an ultra-wide band receiver antenna system. The only thing is a change of terminology, because then the input for the signal effectively becomes an output for the received signal. This output signal is then to be amplified by an amplifier, preferably a low-noise amplifier, instead of being fed to an amplifier before being supplied to the antenna. Yet the same advantages as to useful bandwidth and increased cut-off frequency apply to the receiver antenna system as well, and may be readily imagined by the skilled person.

The invention will now be explained further, with reference to a number of exemplary embodiments and to the drawings, in which
Figure 1a, b shows a prior art antenna system,
Figure 2 shows a first embodiment of the antenna system of the present invention,
Figure 3 shows a second embodiment of the antenna system of the present invention,
Figure 4 diagrammatically shows a cross-sectional side view in more detail of the embodiments of Figures 2 and 3,
Figure 5 shows another embodiment 100" of the antenna system of the present invention,
Fig. 6 diagrammatically shows the electric circuit for driving the system of Fig. 5,
Fig. 7 shows another embodiment of a system 100‴ according to the invention, in a diagrammatic perspective view,
Fig. 8 shows diagrammatically a cross-sectional view through an embodiment 200 of the system according to the invention,
Fig. 9 shows diagrammatically a cross-sectional view through another embodiment of a system 30 according to the invention,
Fig. 10 shows another embodiment of a system 30' according to the invention,
Fig. 11 diagrammatically shows the system 30' of Fig. 10 in somewhat more detail, as a transmitter system, and
Fig. 12 diagrammatically shows the system 30' of Fig. 10, but now laid out as a receiver system.

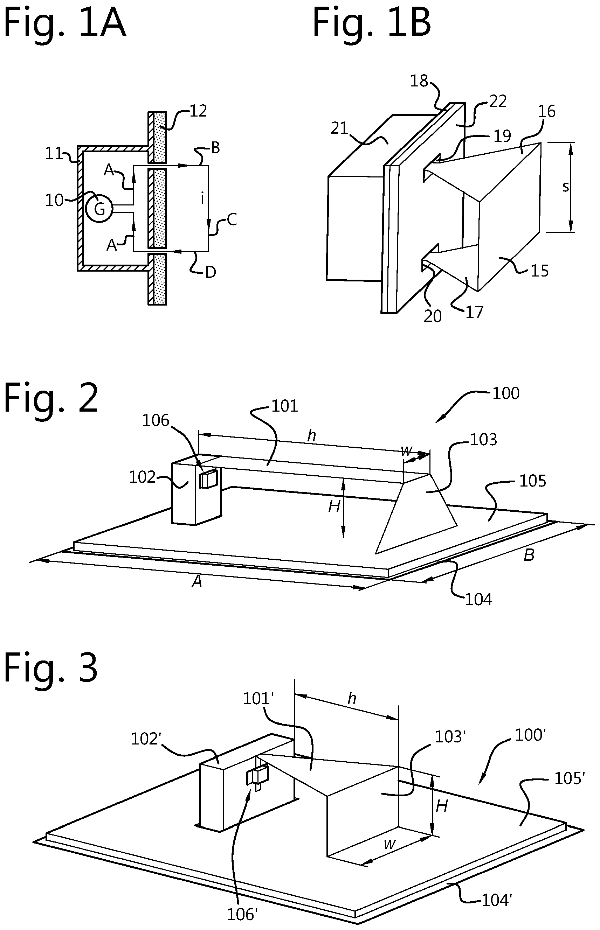

Figure 1a, b shows a prior art antenna system, as provided in US patent no. 4,506,267. Fig. 1a shows a cross-sectional view, and Fig. 1b a diagrammatic perspective view. The system comprises a signal generator 10 in a metal casing 11 (= 21), and connected by means of wires A and trapezoidal sections B (=16) and D (= 17) to a radiating plate C (=15). The casing extends in a metal plane 18 that is clad with an absorber 22 for the emitted electromagnetic radiation.

As can be seen, the trapezoidal sections 16 and 17 are narrow where they enter the casing 21, via holes 19 and 20. This antenna system will have a relatively low cut-off frequency.

Figure 2 shows a first embodiment of the antenna system (100) of the present invention, in a diagrammatic perspective view. The system 100 comprises a radiator plate 101, a first electrical lead 102, a second electrical lead 103, a return plane or ground plane 104, clad with a layer of absorber material 105, and a transistor circuit 106. Not shown here are a power source for the transistor circuit 106, nor a signal generator or input for the signal to be amplified and emitted.

The radiator plate 101 is, as known *per se* in the field, a metal plate that is electrically short with respect to the characteristic length of the radiation to be emitted. As explained above, this means that the length h is shorter than e.g. the wavelength and/or the coherence length of the radiation.

The second electrical lead 103 is shown trapezoidal as in the prior art, but then widening away from the radiating plate 101, and toward the return plane 104. This reduces the parasitic inductance, thus increasing the cut-off frequency of the system 100. Herein, "parasitic inductance" encompasses all of the system inductance that is not related to the inductance of the radiator plate 101, in this case the inductance of the lead 103.

Furthermore, the first electrical lead 102 is shown to be non-narrowing. In particular, the lead 102 is thick, preferably non-wirelike such as rectangular in cross-section, and most preferably the lead 102 is embodied as a heat sink to the transistor circuit 106. In this way, the parasitic inductance is also lowered with respect to the leads 16, 17 in the prior art system, and additionally the lead 102 serves as a heat sink for the transistor circuit 106, in particular the transistor(s) therein, so that these may have a higher power rating. Although not shown here, the heat sink function of the lead 102 may be improved by providing ribs, forced cooling and or other measures known *per se.*

In particular, the body of the heat sink/lead 102 may widen away from the radiator plate 101. Since this increases the average distance between the heat sink body 102 and the radiator plate 101, the parasitic capacitance is also decreased, thereby also increasing the cut-off frequency and avoiding oscillations and ringing respectively.

The ground plane 104 serves as the electrical connection to close the current loop of the first lead 102, the radiator plate 101, the second lead 103 and the transistor circuit 106. Note that the details of the connections to the transistor circuit 106 will be explained further below. The ground plane 104 is clad with absorber material 105, which is a lossy material that will absorb at least a part of the radiation emitted by the radiator plate 101. In fact, radiation will also be emitted by leads 102 and 103, but in the far field these contributions will cancel each other. Furthermore, and as is known in the field, the ground plate 104 plus absorber 105 is preferably larger than the characteristic length of the radiation, to ensure that emitted waves are sufficiently attenuated before reaching the edges and diffracting around to the other side.

Figure 3 shows a second embodiment of the antenna system 100' of the present invention, in a diagrammatic perspective view. Similar parts have been given the same reference numerals, with the addition of one or more primes, as in all of the drawings.

In this embodiment, the radiator plate 101' widens away from the transistor circuit 106' towards the second lead 103'. Again, the average distance between the radiator plate 101' and the transistor circuit 106' increases, further decreasing the parasitic capacitance, and increasing the cut-off frequency, or better the resonance frequency of the system can be moved to beyond the desired frequency band of the antenna system 100'. Herein, it is noted that the narrow part connects to the transistor, that has narrow leads, so that there the current flows in a narrow path through the radiator plate anyway, and not much is lost in terms of the capacity to carry current by narrowing the radiator plate at that position. The highest current density will prevail near the centre of the radiator plate, and only a low current density in the edges nearest the connection to the transistor circuit.

Moreover, the second electrical lead 102' is now non-narrowing, although not widening for the sake of simple manufacturing but could be widened for further reducing parasitic drain-source capacitance. Yet, because it is now very wide over all its length, as wide as the radiator plate 101', it will still have a low (parasitic lead) inductance.

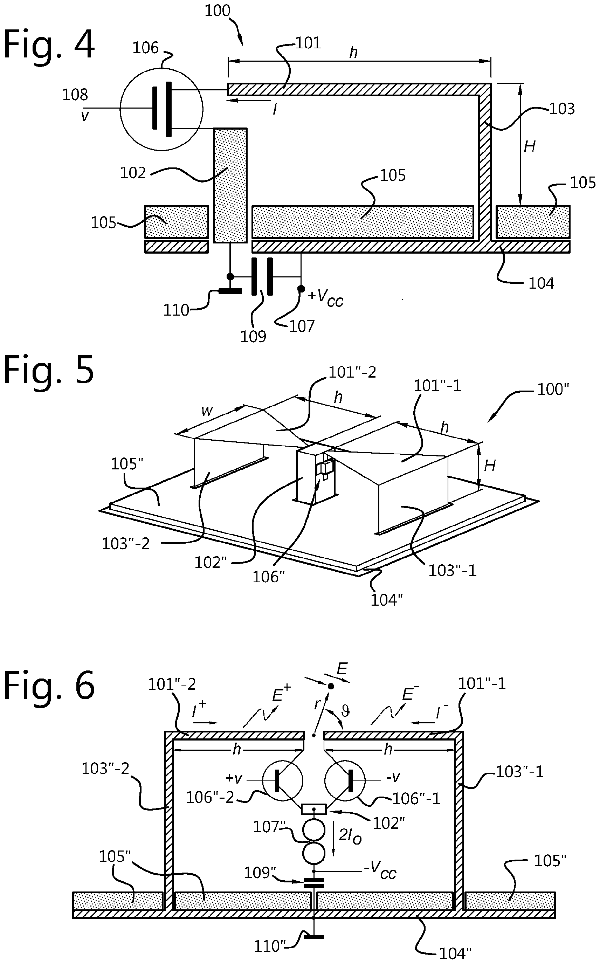

Figure 4 diagrammatically shows a cross-sectional side view in more detail of the embodiments of Figures 2 and 3. It shows that the transistor circuit 106 is provided close to the radiator plate 101, here directly connected thereto. This, i.e. providing the transistor (circuit) in the active region near the radiator plate 101 and above the return (or ground) plane 104 with the absorber 105, allows to have the leads as short as possible, thus reducing lead inductance. It also shows the input 108, where the input signal voltage may be provided, that will be amplified by the transistor circuit 106, based on power that is provided by the power source 107, that is indicated only diagrammatically, and that is typically a battery. As can furthermore be seen, the electrical leads 102 and 103 are connected to the return plane 104 through vias in the absorber 105. The return plane 104 is connected to ground 110 via bypass capacitor 109, that enables the dc voltage of the power source 107 to be separated from the high frequency signals from input 108, as is known *per se*.

The input signal may be provided by means of a signal generator (not shown here) connected to the input 108. The signal generator may be e.g. an arbitrary wave generator, a pulse generator, a sine wave generator with a step or sweep function and so on. Importantly, the present invention relates to ultra-wide band high frequency, that has been explained in the introductory part. At such high frequencies, the behaviour of the leads and other parts of the antenna system may play a decisive role in the total properties.

Figure 5 shows another embodiment 100" of the antenna system of the present invention, and Fig. 6 diagrammatically shows the electric circuit for driving the system of Fig. 5. It comprises two radiator plates 101"-1 and 101"-2, as well as two corresponding second electrical leads 103"-1 and 103"-2. The transistor circuit 106" comprises two separate transistor circuits, in Fig. 6 denoted as 106"-1 and 106"-2, both powered by a power source 107", that is in this case a constant current source. Via the usual power supply bypass capacitor 109 the source 107" is connected to ground 110" and the return plate (or in this case ground plane) 104". The two first electrical leads are shown combined as 102", although in practice it will often also be provided as two separate leads from the power supply (constant current source) to the two transistors (or ~ circuits). There may still be provided one or two heat sink(s) at the leads from the power supply to the transistors.

This embodiment is able to provide a twice as strong field at large distances, especially for cases in which one radiator plate 101 "-1 could not be made longer, because that would lead to a too high inductance of the current loop, and thus a too high power dissipation in the transistor 106". By providing a second current loop/radiator plate, the effective length of the (total) radiator may increase, and by cascading the additional radiator plate 101 "-2 with an additional transistor, driven with opposite current, the far-field electric field strength may be doubled.

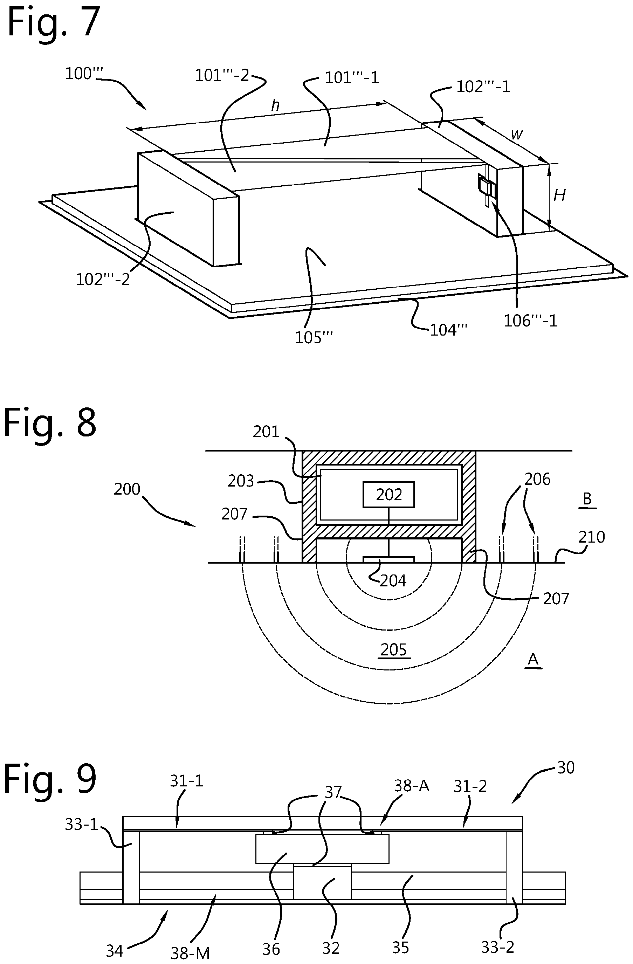

Fig. 7 shows another embodiment of a system 100‴ according to the invention, in a diagrammatic perspective view. Here, the two radiator plates 101‴-1 and 101‴-2 are positioned side-by-side, and are preferably widening away from the first electrical lead near the transistor circuit 106"'-1 and the non-shown equivalent for the second radiator plate. Cascaded differentially driven transistors 106"'-1 and its equivalent for the other radiator plate 101‴-2 drive currents through the plates 101‴ that are again opposite one another.

This gives a compact system in case the radiator plate length may not be extended above the length h for one plate while still increasing the far-field electric field strength by a factor of two, or in case there are other geometric constraints that do not allow to use the full length h of a single radiator plate.

Fig. 8 shows diagrammatically a cross-sectional view through an embodiment 200 of the system according to the invention, with a metal casing 201 surrounding electronics 202. Absorber material is indicated with 203, as well as extending legs 207, and a radiator plate with 204, emitting electromagnetic waves 205 into medium A, as well as evanescent waves 206 into air B, with a boundary 210.

In this embodiment, the electronics 202 comprise e.g. a signal generator and/or an antenna for detecting electromagnetic radiation coming from, e.g. reflected by, the medium A, such as the ground. In order to prevent picking up directly waves emitted by the radiator plate 204, the electronics 202 are surrounded by a metal casing 202, that is clad at the bottom thereof with a layer of absorbing (or "lossy") material. However, in the absence of the legs 207 and the layers of absorbing material on the sides and top of the casing 201, the radiator plate 204 and/or an antenna nearby, could also be influenced by so-called "creeping waves", which are waves emitted into the air, and diffracting around the edges of the casing and running along the surface of, and thus around, the metal casing 201.

By providing the legs 207 of absorbing material around the radiator plate 204, the waves that the radiator plate 204 emits directly into the air B are then absorbed (to a certain extent). This means that the waves are only transmitted as the radiation 205, the probing radiation into the medium A. Yet, at the boundary 210 they might propagate into the air B, but only as evanescent waves, thus quickly damping out.

In case the legs 207 do not perfectly close off the space around the radiator plate 204, waves could still escape. Therefore, it is advantageous to clad the metal casing 201 all around with absorber material 203, i.e. also on the sides and on top. In this way, if there is a "creeping wave" over the surface of the metal casing, it will still be attenuated quickly, so that it will not interfere with the desired radiation to an unwanted degree.

Fig. 9 shows diagrammatically a cross-sectional view through another embodiment of a system 30 according to the invention. Herein, 31-1 and 31-2 are two radiator plates, 32 is a heat sink/electrical lead, 33-1 and 33-2 are electrical leads (plates or trapezoidal or the like), 34 is a ground plate, 35 is a layer of absorber material, 36 is an integrated circuit (IC), 37 denote contact pads, and 38-M and 38-A are the main, the additional printed circuit board, hereinafter 'PCB'.

The IC 36 has contact pads at the bottom and top of the housing, but permits to provide the IC in the centre of the current loop, i.e. between the radiator plates 31-1 and -2, and the ground plane 34. Put in other words, since the radiator plates 31-1 and - 2 are provided on the additional PCB 38-A, and the ground plane 34 and absorber layer 35 are provided on the main PCB 38-M, there is optimum protection for the IC 36. Also, and no less important, since the additional PCB 38-A that carries the antennae or radiator plates 31-1 and -2 is preferably made of an inert material, it becomes easy to directly contact a medium or object to be investigated with the system 30, which is advantageous for e.g. contact based UWB-microwave imaging or substance analysis.

Note that here, as in practically all other embodiments discussed above and below, it is possible to provide only one radiator plate 31, or also e.g. four radiator plates crosswise, such as with two of the systems of Figure 5 arranged crosswise, as cascaded differentially driven radiators. It is also possible to provide an array of antennae/radiator plates, e.g. on one and the same (main) PCB.

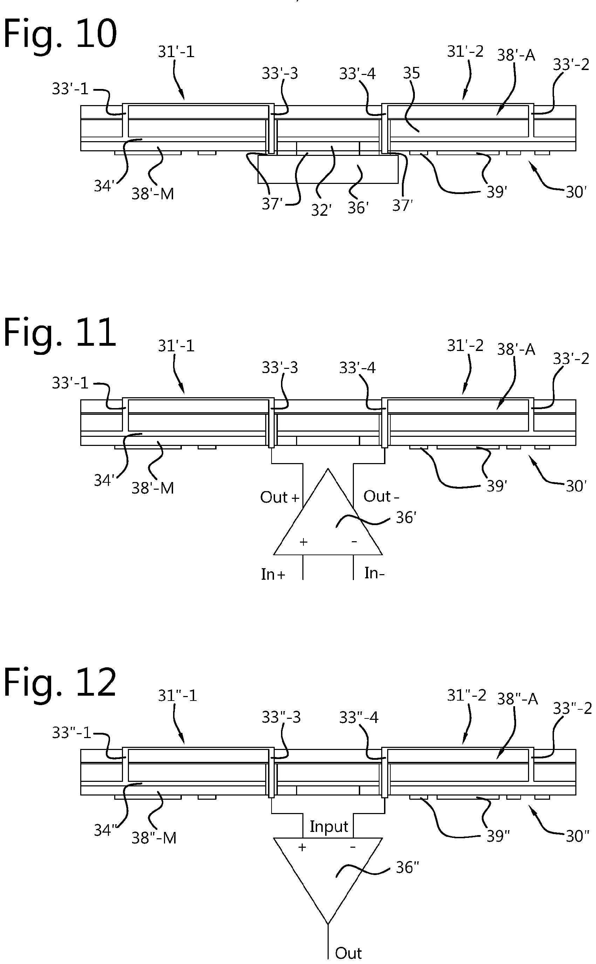

Fig. 10 shows another embodiment of a system 30' according to the invention. Here, 33'-1 and 33'-2 are each a plurality of vias to the ground plane 34, and 33'-3 and 33'-4 are each one or a few vias to the respective radiator plate. Note herein that the radiator plates 31'-1 and 31'-2 are widening towards the vias 33', such as trapezoidally or triangularly. However, because they are vias, the second electrical leads 33'-1 and 33'-2 cannot be flat plates or similarly wide leads. Thus, the lead inductance will be somewhat higher. But the IC 36 can now be a standard casing, and is provided outside the radiation volume, i.e. "behind" the layer 35 of absorber material. And the surface of the antenna, i.e. the radiator plates 31'-1 and 31'-2 is now completely flat, and can be brought directly and intimately into contact with the medium of investigation, which is important for e.g. medical imaging.

Fig. 11 diagrammatically shows the system 30' of Fig. 10 in somewhat more detail, as a transmitter system. The transistor circuit or amplifier 36 (here a fully differential power amplifier) has a (differential) input at In+ and In-, where the input voltage signal may be applied. The amplifier 36' amplifies this signal into the probing signals at the outputs Out+ and Out-, from which they are fed into the radiator plates 31'-1, 31'-2, respectively.

Fig. 12 diagrammatically shows the system 30' of Fig. 10, but now laid out as a receiver system.

In this embodiment, there is a low-noise amplifier 36", that acts as the voltage sensor. It is fed by two input signals at the inputs + and -, from which an amplified output is generated and output at the output Out. Again, the system 30" shown is laid out for a symmetrical antenna design. Note that a single radiator plate, or more such as four, is also possible, with corresponding adaptations in the wiring of the amplifier.

As a general remark, it is noted that all embodiments may be set-up as a transmitter system or as a receiver system, by correspondingly connecting an appropriate transistor circuit.

## Claims

1. Ultra-wide band antenna system (100; 30) for emitting or receiving electromagnetic radiation in a desired ultra-wide frequency band,
the antenna system comprising
- an electrically short radiator plate (101; 31-1, 31-2),
- a power unit having an input configured for receiving an input signal that is detected or to be emitted via the radiator plate, a power supply (107) and a transistor circuit (106; 36) for amplifying the input signal,
and
- a current loop configured for electrically connecting the radiator plate and the power unit into an electrical loop,
wherein the current loop comprises
- a return conductor being a ground plane (104; 34), and a layer of absorber material (105; 35) between the radiator plate and the ground plane configured to absorb electromagnetic radiation in said desired frequency band,
- a first electrical lead (102) connecting the ground plane to the power unit, and
- a second electrical lead (103; 33-1, 33-2) connecting the ground plane to the radiator plate,
wherein the first electrical lead is non-narrowing away from the radiator plate, and wherein the first electrical lead has a rectangular cross-section and/or widens away from the radiator plate.

2. The system of claim 1, wherein the second electrical lead (103; 33-1, 33-2) widens from the radiator plate towards the ground plane.

3. System according to claim 1 or 2, wherein the first and/or second electrical lead widens linearly.

4. System according to any preceding claim, wherein at least the transistor circuit and the radiator plate are provided on the same side of the ground plane and of the layer of absorbing material.

5. System according to any preceding claim, wherein the radiator plate is arranged as a heat sink to the transistor circuit.

6. System according to any preceding claim, wherein the first electrical lead is arranged as a heat sink (32) to the transistor circuit.

7. System according to claim 6, wherein the heat sink narrows towards the transistor circuit.

8. System according to any preceding claim, wherein the radiator plate widens from the first electrical lead towards the second electrical lead.

9. System according to any preceding claim, wherein the transistor circuit is arranged to have a decaying frequency-dependent gain curve in at least a part of said desired ultra-wide frequency band.

10. System according to any preceding claim, comprising a signal generator (202) arranged to generate an input signal for inputting into said input, in particular wherein the input signal substantially only has frequency components within said desired ultra-wide frequency band.

11. System according to any preceding claim, wherein the ground plane and the layer of absorber material are sandwiched to a main printed circuit board (38-M), wherein at least the transistor circuit (36) is provided in a package mounted on an additional printed circuit board (38-A) that is sandwiched to the radiator plate, wherein the heat sink (32) is provided to contact the ground plane and the package directly.

12. System according to any preceding claim, wherein the system comprises a second antenna system, comprising
- a second electrically short radiator plate (101‴-2),
- a second power unit having an input for receiving an input signal to be emitted as a probing signal via the radiator plate, and a second transistor circuit for amplifying the input signal into the probing signal,
- a second current loop for electrically connecting the second radiator plate and the second power unit into a second electrical loop, the current loop comprising
- the ground plane (104‴) and the layer of absorber material (105‴) to absorb electromagnetic radiation in said desired frequency band,
- a first additional electrical lead connecting the second power unit to the ground plane,
- a second additional electrical lead connecting the ground plane to the second radiator plate.

13. System according to claim 12, wherein the radiator plate and the second radiator plate are both arranged on the additional printed circuit board, preferably wherein the power unit and the second power unit are both provided between the main printed circuit board and the additional printed circuit board, more preferably wherein both the transistor circuit and the second transistor circuit are provided in one and the same package.

14. System according to any preceding claim, further comprising a metal casing (201) with electronic parts (202) provided therein that are arranged to generate a probing signal or detect a detection signal by means of the antenna system, wherein the metal casing is substantially fully clad with an absorber material (203) to absorb electromagnetic radiation in said desired frequency band.

15. System according to claim 14, wherein the radiator plate is external to the metal casing at a first side of said metal casing, the system further comprising a continuous wall (207) extending from the metal casing and surrounding the radiator plate (204) on all sides, wherein the wall is also clad with absorber material to absorb electromagnetic radiation (205) in said desired frequency band.

## Patentansprüche

1. Ultrabreitband-Antennensystem (100; 30) zum Emittieren oder Empfangen von elektromagnetischer Strahlung in einem gewünschten Ultrabreit-Frequenzband, wobei das Antennensystem Folgendes umfasst:
- eine elektrisch kurze Strahlerplatte (101; 31-1, 31-2),
- eine Leistungseinheit mit einem Eingang, der zum Empfangen eines Eingangssignals, das über die Strahlerplatte detektiert wird oder emittiert werden soll, ausgelegt ist, einer Leistungsversorgung (107) und einer Transistorschaltung (106; 36) zum Verstärken des Eingangssignals,
und
- eine Stromschleife, die dazu ausgelegt ist, die Strahlerplatte und die Leistungseinheit in eine elektrische Schleife elektrisch zu verbinden,
wobei die Stromschleife Folgendes umfasst:
- einen Rückkehrleiter, bei dem es sich um eine Massefläche (104; 34) handelt, und eine Schicht eines Absorbermaterials (105; 35) zwischen der Strahlerplatte und der Massefläche, ausgelegt zum Absorbieren von elektromagnetischer Strahlung in dem gewünschten Frequenzband,
- eine erste elektrische Zuleitung (102), die die Massefläche mit der Leistungseinheit verbindet, und
- eine zweite elektrische Zuleitung (103; 33-1, 33-2), die die Massefläche mit der Strahlerplatte verbindet,
wobei die erste elektrische Zuleitung von der Strahlerplatte weg nicht-verjüngend ist und wobei die erste elektrische Zuleitung einen rechteckigen Querschnitt aufweist und/oder sich von der Strahlerplatte weg ausweitet.

2. System nach Anspruch 1, wobei sich die zweite elektrische Zuleitung (103; 33-1, 33-2) von der Strahlerplatte in Richtung der Massefläche ausweitet.

3. System nach Anspruch 1 oder 2, wobei sich die erste und/oder zweite elektrische Zuleitung linear ausweitet.

4. System nach einem der vorhergehenden Ansprüche, wobei zumindest die Transistorschaltung und die Strahlerplatte auf derselben Seite der Massefläche und der Schicht des Absorbierungsmaterials bereitgestellt sind.

5. System nach einem der vorhergehenden Ansprüche, wobei die Strahlerplatte als Wärmesenke für die Transistorschaltung angeordnet ist.

6. System nach einem der vorhergehenden Ansprüche, wobei die erste elektrische Zuleitung als Wärmesenke (32) für die Transistorschaltung angeordnet ist.

7. System nach Anspruch 6, wobei sich die Wärmesenke in Richtung der Transistorschaltung verjüngt.

8. System nach einem der vorhergehenden Ansprüche, wobei sich die Strahlerplatte von der ersten elektrischen Zuleitung in Richtung der zweiten elektrischen Zuleitung ausweitet.

9. System nach einem der vorhergehenden Ansprüche, wobei die Transistorschaltung so eingerichtet ist, dass sie eine abnehmende Kurve der frequenzabhängigen Verstärkung in mindestens einem Teil des gewünschten Ultrabreit-Frequenzbands aufweist.

10. System nach einem der vorhergehenden Ansprüche, umfassend einen Signalgenerator (202), der dazu eingerichtet ist, ein Eingangssignal zur Eingabe in den Eingang zu erzeugen, insbesondere wobei das Eingangssignal im Wesentlichen nur Frequenzkomponenten in dem gewünschten Ultrabreit-Frequenzband aufweist.

11. System nach einem der vorhergehenden Ansprüche, wobei die Massefläche und die Schicht des Absorbermaterials auf einer Hauptleiterplatte (38-M) schichtartig angeordnet sind, wobei zumindest die Transistorschaltung (36) in einem auf einer zusätzlichen Leiterplatte (38-A) montierten Gehäuse bereitgestellt ist, das auf der Strahlerplatte schichtartig angeordnet ist, wobei die Wärmesenke (32) so bereitgestellt ist, dass sie die Massefläche und das Gehäuse direkt kontaktiert.

12. System nach einem der vorhergehenden Ansprüche, wobei das System ein zweites Antennensystem umfasst, das Folgendes umfasst:
- eine zweite elektrisch kurze Strahlerplatte (101‴-2),
- eine zweite Leistungseinheit mit einem Eingang zum Empfangen eines Eingangssignals, das als Sondierungssignal über die Strahlerplatte emittiert werden soll, und einer zweiten Transistorschaltung zum Verstärken des Eingangssignals in das Sondierungssignal,
- eine zweite Stromschleife zum elektrischen Verbinden der zweiten Strahlerplatte und der zweiten Leistungseinheit in eine zweite elektrische Schleife, wobei die Stromschleife Folgendes umfasst:
- die Massefläche (104‴) und die Schicht des Absorbermaterials (105‴) zum Absorbieren von elektromagnetischer Strahlung in dem gewünschten Frequenzband,
- eine erste zusätzliche elektrische Zuleitung, die die zweite Leistungseinheit mit der Massefläche verbindet,
- eine zweite zusätzliche elektrische Zuleitung, die die Massefläche mit der zweiten Strahlerplatte verbindet.

13. System nach Anspruch 12, wobei die Strahlerplatte und die zweite Strahlerplatte beide auf der zusätzlichen Leiterplatte angeordnet sind, wobei vorzugsweise die Leistungseinheit und die zweite Leistungseinheit beide zwischen der Hauptleiterplatte und der zusätzlichen Leiterplatte bereitgestellt sind, wobei noch bevorzugter sowohl die Transistorschaltung als auch die zweite Transistorschaltung in ein und demselben Gehäuse bereitgestellt sind.

14. System nach einem der vorhergehenden Ansprüche, ferner umfassend ein Metallgehäuse (201) mit darin bereitgestellten elektronischen Teilen (202), die dazu eingerichtet sind, ein Sondierungssignal zu erzeugen oder mittels des Antennensystems ein Detektionssignal zu detektieren, wobei das Metallgehäuse im Wesentlichen vollständig mit einem Absorbermaterial (203) zum Absorbieren von elektromagnetischer Strahlung in dem gewünschten Frequenzband verkleidet ist.

15. System nach Anspruch 14, wobei sich die Strahlerplatte außerhalb des Metallgehäuses an einer ersten Seite des Metallgehäuses befindet, wobei das System ferner eine durchgehende Wand (207) umfasst, die sich von dem Metallgehäuse erstreckt und die Strahlerplatte (204) an allen Seiten umgibt, wobei die Wand ebenfalls mit Absorbermaterial zum Absorbieren von elektromagnetischer Strahlung (205) in dem gewünschten Frequenzband verkleidet ist.

## Revendications

1. Système d'antenne à ultralarge bande (100 ; 30) pour émettre ou recevoir un rayonnement électromagnétique dans une bande de fréquence ultralarge souhaitée, le système d'antenne comprenant
- une plaque rayonnante courte électriquement (101 ; 31-1, 31-2),
- une unité de puissance ayant une entrée configurée pour recevoir un signal d'entrée détecté ou à émettre via la plaque rayonnante, une alimentation électrique (107) et un circuit transistor (106 ; 36) pour amplifier le signal d'entrée,
et
- une boucle de courant configurée pour connecter électriquement la plaque rayonnante et l'unité de puissance en une boucle électrique,
la boucle de courant comprenant
- un conducteur de retour qui est un plan de masse (104 ; 34), et une couche de matériau absorbant (105 ; 35) entre la plaque rayonnante et le plan de masse configuré pour absorber un rayonnement électromagnétique dans ladite bande de fréquence souhaitée,
- un premier élément conducteur électrique (102) connectant le plan de masse à l'unité de puissance, et
- un deuxième élément conducteur électrique (103 ; 33-1, 33-2) connectant le plan de masse à la plaque rayonnante, le premier élément conducteur électrique ne se rétrécissant pas en s'éloignant de la plaque rayonnante, et
le premier élément conducteur électrique ayant une section transversale rectangulaire et/ou s'élargissant en s'éloignant de la plaque rayonnante.

2. Système selon la revendication 1, le deuxième élément conducteur électrique (103 ; 33-1, 33-2) s'élargissant de la plaque rayonnante vers le plan de masse.

3. Système selon la revendication 1 ou 2, les premier et/ou deuxième élément(s) conducteur(s) électrique(s) s'élargissant linéairement.

4. Système selon l'une quelconque des revendications précédentes, au moins le circuit transistor et la plaque rayonnante étant prévus sur le même côté du plan de masse et de la couche de matériau absorbant.

5. Système selon l'une quelconque des revendications précédentes, la plaque rayonnante étant agencée en tant que puits de chaleur au circuit transistor.

6. Système selon l'une quelconque des revendications précédentes, le premier élément conducteur électrique étant agencé en tant que puits de chaleur (32) au circuit transistor.

7. Système selon la revendication 6, le puits de chaleur se rétrécissant vers le circuit transistor.

8. Système selon l'une quelconque des revendications précédentes, la plaque rayonnante s'élargissant du premier élément conducteur électrique vers le deuxième élément conducteur électrique.

9. Système selon l'une quelconque des revendications précédentes, le circuit transistor étant agencé pour avoir une courbe de gain dépendant de la fréquence déclinante dans au moins une partie de ladite bande de fréquence ultralarge souhaitée.

10. Système selon l'une quelconque des revendications précédentes, comprenant un générateur de signal (202) agencé pour générer un signal d'entrée pour une introduction dans ladite entrée, en particulier le signal d'entrée ayant sensiblement seulement des composantes de fréquence dans ladite bande de fréquence ultralarge souhaitée.

11. Système selon l'une quelconque des revendications précédentes, le plan de masse et la couche de matériau absorbant intercalant une carte de circuit imprimé principale (38-M), au moins le circuit transistor (36) étant prévu dans une enveloppe fixée sur une carte de circuit imprimé additionnelle (38-A) intercalant la plaque rayonnante, le puits de chaleur (32) étant prévu pour mettre en contact directement le plan de masse et l'enveloppe.

12. Système selon l'une quelconque des revendications précédentes, le système comprenant un deuxième système d'antenne, comprenant
- une deuxième plaque rayonnante courte électriquement (101"'-2),
- une deuxième unité de puissance ayant une entrée pour recevoir un signal d'entrée à émettre en tant que signal de sondage via la plaque rayonnante, et un deuxième circuit transistor pour amplifier le signal d'entrée en signal de sondage,
- une deuxième boucle de courant pour connecter électriquement la deuxième plaque rayonnante et la deuxième unité de puissance dans une deuxième boucle électrique, la boucle de courant comprenant
- le plan de masse (104‴) et la couche de matériau absorbant (105‴) pour absorber un rayonnement électromagnétique dans ladite bande de fréquence souhaitée,
- un premier élément conducteur électrique additionnel connectant la deuxième unité de puissance au plan de masse,
- un deuxième élément conducteur électrique additionnel connectant le plan de masse à la deuxième plaque rayonnante.

13. Système selon la revendication 12, la plaque rayonnante et la deuxième plaque rayonnante étant toutes les deux agencées sur la carte de circuit imprimé additionnelle, de préférence l'unité de puissance et la deuxième unité de puissance étant toutes les deux prévues entre la carte de circuit imprimé principale et la carte de circuit imprimée additionnelle, plus préférablement à la fois le circuit transistor et le deuxième circuit transistor étant prévus dans un seul et même boitier.

14. Système selon l'une quelconque des revendications précédentes, comprenant en outre un boitier métallique (201) avec des parties électroniques (202) prévues en son sein qui sont agencées pour générer un signal de sondage ou détecter un signal de détection au moyen du système d'antenne, le boitier métallique étant sensiblement recouvert entièrement d'un matériau absorbant (203) pour absorber un rayonnement électromagnétique dans ladite bande de fréquence souhaitée.

15. Système selon la revendication 14, la plaque rayonnante étant à l'extérieur du boitier métallique au niveau d'un premier côté dudit boitier métallique, le système comprenant en outre une paroi continue (207) s'étendant depuis le boitier métallique et entourant la plaque rayonnante (204) sur tous les côtés, la paroi étant également recouverte de matériau absorbant pour absorber un rayonnement électromagnétique (205) dans ladite bande de fréquence souhaitée.
